(19) Europäisches Patentamt
European Patent Office
Office européen des brevets

(11) Numéro de publication : **0 526 284 A1**

# (12) DEMANDE DE BREVET EUROPEEN

(21) Numéro de dépôt : **92401914.4**

(51) Int. Cl.$^5$ : **G03F 7/00,** G03F 7/031

(22) Date de dépôt : **03.07.92**

(30) Priorité : **05.07.91 FR 9108461**

(43) Date de publication de la demande :
**03.02.93 Bulletin 93/05**

(84) Etats contractants désignés :
**AT BE CH DE DK ES FR GB GR IT LI LU MC NL PT SE**

(71) Demandeur : **CENTRE NATIONAL D'ETUDES SPATIALES**
**2, Place Maurice Quentin**
**F-75001 Paris (FR)**

(72) Inventeur : **Lougnot, Daniel-Joseph**
**13, rue Fénelon**
**F-68200 Mulhouse (FR)**
Inventeur : **Noiret-Roumier, Nadine**
**80, rue Salengro**
**F-68100 Mulhouse (FR)**
Inventeur : **Faup, Michel**
**42, rue du Canon d'Arcole**
**F-31000 Toulouse (FR)**

(74) Mandataire : **Colas, Jean-Pierre et al**
**Cabinet de Boisse 37, avenue Franklin D. Roosevelt**
**F-75008 Paris (FR)**

## (54) Compositions photopolymerisables, sensibles dans le rouge, utiles pour l'enregistrement d'hologrammes.

(57) L'invention concerne des compositions photopolymérisables, caractérisées en ce qu'elles consistent en une solution de :

(I) au moins une substance choisie dans le groupe constitué par :
(A) les monomères contenant au moins une double liaison éthylénique,
(B) les oligomères acryliques ou méthacryliques polyfonctionnels, et
(C) les composés d'addition dérivés d'un acrylate ou méthacrylate de polyol et d'un acide acrylique, ou dérivés d'un oligomère I(B) et d'un acide acrylique.
(II) un système générateur de radicaux libres comprenant
(D) au moins un agent réducteur organique,
(E) au moins un agent renforçateur de l'effet quantique,
(F) au moins un agent absorbeur de lumière dont le spectre d'absorption s'étend entre 600 nm et le proche infrarouge.

Application à la production d'hologrammes de phase.

EP 0 526 284 A1

L'invention concerne des compositions photopolymérisables, sensibles dans le rouge et le proche infrarouge, utiles pour l'enregistrement d'hologrammes,en particulier d'hologrammes de phase, épais ou minces.

Un hologramme de phase est constitué de variations locales de l'indice de réfraction du milieu d'enregistrement.

Les compositions de l'invention présentent l'avantage de permettre de réaliser in situ des enregistrements holographiques qui sont utilisables sans traitement physique ou chimique subséquent visant à inactiver la composition ou à révéler l'information. Du fait de leur sensibilité spectrale particulière, elles peuvent être manipulées en lumière bleue sans risque d'altération.

Plus précisément, l'invention concerne des compositions photopolymérisables, sensibles dans le rouge et le proche infrarouge, caractérisées en ce qu'elles consistent essentiellement en une solution de :

(I) au moins une substance, non gazeuse, éthyléniquement insaturée, capable de former un haut polymère par polymérisation d'addition, à propagation en chaîne initiée par des radicaux libres, choisie dans le groupe constitué par :

(A) les monomères contenant au moins une double liaison éthylénique,

(B) les oligomères acryliques ou méthacryliques polyfonctionnels d'une masse moléculaire de 500 à 5000, et

(C) les composés d'addition dérivés d'un acrylate ou méthacrylate de polyol et d'un acide acrylique, ou dérivés d'un oligomère I(B) et d'un acide acrylique.

(II) un système générateur de radicaux libres, sensible à des radiations comprises entre 600 nm et le proche infrarouge, comprenant

(D) au moins un agent réducteur organique,

(E) au moins un agent renforçateur de l'effet quantique,

(F) au moins un agent absorbeur de lumière dont le spectre d'absorption s'étend entre 600 nm et le proche infrarouge et qui, conjointement avec les constituants (D) et (E), est capable d'engendrer des espèces actives susceptibles d'amorcer la photopolymérisation du constituant (I).

Outre les constituants (D), (E) et (F), le système générateur de radicaux libres (II) peut comprendre, de façon facultative, un agent stabilisateur d'amorçage (G).

Les compositions de l'invention peuvent comprendre également de façon facultative mais préférée, au moins un inhibiteur de polymérisation thermique (III).

Les compositions de l'invention ne nécessitent pas l'emploi d'un solvant, la substance polymérisable (I) remplissant ce rôle.

Des exemples du constituant (I)(A) sont, à titre illustratif et non limitatif, des acrylates et méthacrylates de polyols tels que le triacrylate de pentaérythritol (PETA), le diacrylate de tripropylène glycol (TPGDA), le diacrylate d'hexanediol (HDDA), le tétracrylate de pentaérythritol, le triacrylate de triméthylolpropane, le méthacrylate d'allyle, le diacrylate de butanediol ou le diacrylate de bisphénol A éthoxylé ; des acrylamides et méthacrylamides insaturés, tels que l'acrylamide, le diméthylacrylamide, ou le méthylène-bis-acrylamide ; ou des composés vinyliques tels que le vinyl-9-carbazole, l'adipate de divinyle, le phtalate de divinyle, le styrène et ses dérivés. D'autres exemples peuvent être trouvés dans US-A-3 261 686, US-A-3 380 831 et EP-A-324482, dont les enseignements sont incorporés ici par référence.

Des exemples du constituant (I)(B) sont, à titre illustratif et non limitatif, des uréthanes-acrylates ouméthacrylates aliphatiques ou aromatiques, des époxyacrylates ou des polyesteracrylates. Des constituants (I)(B) sont disponibles dans le commerce, par exemple le CN953 et homologues disponibles auprès de la Société CRAYNOR, 92800 Puteaux, France et l'Ebecryl® 850 et homologues disponibles auprès de la Société commerciale UCB, 92003 Nanterre, France.

Des exemples du constituant (I)(C) sont, à titre illustratif et non limitatif, les composés d'addition formés par l'un quelconque des acrylates et méthacrylates de polyols mentionnés pour le constituant (I)(A) et d'un acide acrylique tel que l'acide acrylique ou méthacrylique. On préfère que le constituant (I) comprenne un constituant (I)(C), c'est à dire un composé d'addition dérivant de l'acide acrylique, en raison de sa réactivité supérieure.

Le choix des constituants entrant dans la composition de la substance polymérisable (I) sera habituellement fait en fonction de la viscosité désirée pour la composition photopolymérisable, qui doit être adaptée à la technique d'application de la composition sur un support convenable en vue d'obtenir un élément convenant à la production d'un hologramme de phase. Par exemple, pour un étalement de la composition à l'aide d'une racle calibrée, la viscosité de la composition photopolymérisable sera habituellement avantageusement comprise entre 100 et 1000 mPa.s.

Des exemples de l'agent réducteur organique (II)(D) sont, à titre illustratif et non limitatif, des amines aliphatiques ou aromatiques comme la méthyldiéthanolamine, la triéthanolamine, le p-diméthylaminobenzoate d'éthyle, des thiols, des sulfinates, des trialkylaryl stannanes, l'acide ascorbique, et la N-phénylglycine, qui

sont tous des composés réducteurs bien connus.

L'agent renforçateur (II)(E) de l'effet quantique est un composé organique contenant au moins un atome dont la masse moléculaire est supérieure à 16 comme ceux décrits par exemple dans US-A-4 258 111. Des exemples illustratifs et non limitatifs de l'agent renforçateur (II)(E) sont des composés contenant un ou plusieurs atomes de Br, I, S ou Fe, tels que l'iodoforme $CHI_3$, le tétrabromure de carbone $CBr_4$, les mercaptobenzothiazoles, le ($\eta^5$-2,4-cyclopentadien-1-yl)[(1,2,3,4,5,6-$\eta$)-(1-méthyléthyl)benzène] de fer II hexafluorophosphate, l'hexafluoroantimonate de phényl-4-octyloxyphényl iodonium.

L'agent absorbeur de lumière (II)(F) peut être tout composé dont le spectre d'absorption s'étend entre 600 nm et le proche infrarouge. A titre d'exemples illustratifs et non limitatifs, on peut citer les polyméthines de la formule générale

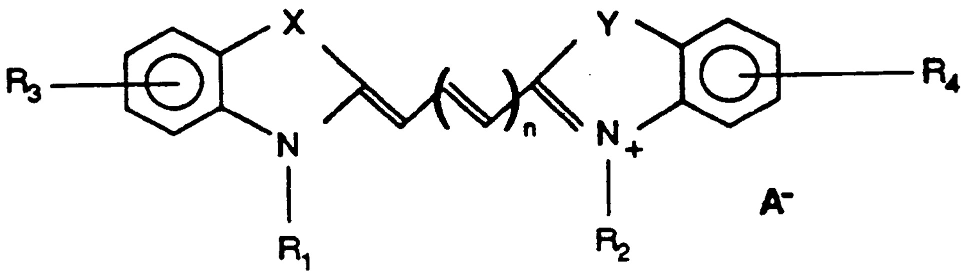

où X et Y sont choisis, de façon indépendante, parmi -N-, -S-, - Se-, -O-, $-CH_2-CH_2-$ et $-C(CH_3)_2-$ ;

$R_1$ et $R_2$ représentent indépendamment un radical alkyle ou alkyle substitué, $R_3$ et $R_4$ représentent indépendamment un radical alkyle ou alkyle substitué, $-CF_3$, $-NO_2$, amino substitué ou non, alcoxy substitué ou non, F, Cl, Br, I ou un radical aromatique condensé ; et n = 2 ou 3. Il est à noter que les groupes $R_1$, $R_2$, $R_3$ et $R_4$ peuvent être substitués de façon à conférer à la polyméthine des propriétés particulières, par exemple des caractéristiques de solubilité modifiées. Des exemples de substituants sont, par exemple, le groupe sulfonate ou le groupe ammonium quaternaire.

Sont également utiles les polyméthines dont la chaîne centrale est substituée, en particulier dont la chaîne centrale porte un atome d'iode sur le carbone médian.

L'agent renforçateur (II)(E) et l'absorbeur de lumière (II)(F) forment un couple dans lequel l'agent renforçateur exerce un effet purement physique appelé "effet d'atome lourd" sur l'absorbeur. Lorsque l'absorbeur est exposé a un rayonnement situé dans le rouge ou proche infrarouge. Cet effet porte l'absorbeur de lumière dans un état où il est capable, en combinaison avec le réducteur (II)(D), d'amorcer la réaction de polymérisation.

L'agent stabilisateur d'amorçage (II)(G) facultatif peut être toute molécule AB susceptible de donner lieu à un transfert radicalaire du type suivant :

$$R^0 + AB \rightarrow RA \rightarrow B^0$$

où $R^0$ est une espèce radicalaire obtenue par action de la lumière sur le mélange constitué de l'agent réducteur (II)(D) et de l'agent absorbeur de la lumière (II)(F). A titre illustratif et non limitatif, le constituant (II)(G) peut être un composé carbonylé tel que :

- la benzoïne et ses dérivés comme les éthers de benzoïne ou de méthylbenzoïne, par exemple les éthers méthylique, éthylique et phénylique,
- des cétones aromatiques comme l'hydroxycyclohexylphénone,

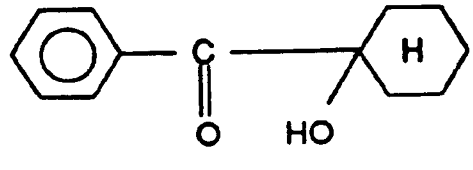

- des esters d'oximinocétone de la formule générale

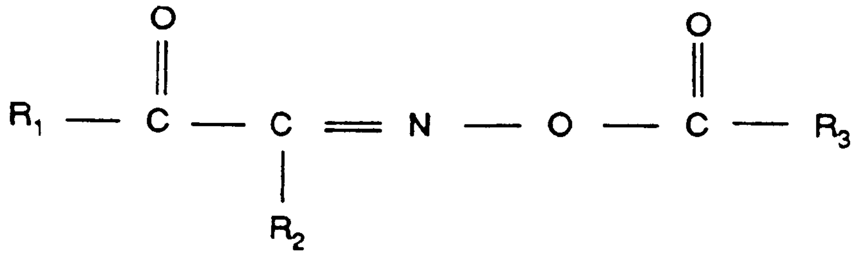

où $R_1$, $R_2$ et $R_3$ représentent divers substituants. Un exemple spécifique d'un tel ester est le PDO ($R_1$ = phényle, $R_2$ = méthyle et $R_3$ éthyle),

- les dérivés de 2,4,5 triarylimidazoles (appelés aussi hexaarylbiimidazoles), tels que ceux décrits dans US-A-3 479 185,
- des dérivés de thioxanthone, par exemple l'isopropylthioxanthone.

L'inhibiteur de polymérisation thermique (III) facultatif mais préféré est, comme cela est classique dans le domaine des compositions photopolymérisables, constitué habituellement d'un dérivé d'hydroquinone tel que, de façon indicative, le méthoxyphénol. D'autres exemples d'inhibiteurs (III) peuvent être trouvés dans US-A-3 658 526 dont les enseignements sont incorporés ici par référence.

Il est à noter, en outre, qu'il est possible d'utiliser des composés remplissant plusieurs fonctions. Ainsi, par exemple, il est possible d'utiliser une substance polymérisable (I)(A) ou (I)(B) servant en même temps d'agent réducteur organique (II)(D). Des exemples d'une telle substance sont par exemple, les acrylates et méthacrylates d'aminoalkyle tel que le méthacrylate d'aminoéthyle.

Egalement, il est possible d'avoir recours à une substance polymérisable (I)(A) ou (I)(B) jouant en même temps le rôle de l'agent renforçateur (II)(E).

Des exemples d'une telle substance sont, par exemple, le diacrylate de tétrabromobisphénol-A ou les acrylates de métaux.

Les constituants sus-mentionnés peuvent être présents dans la composition de l'invention en des proportions très variables. A titre indicatif, ces proportions peuvent être approximativement les suivantes :

| Constituants | gamme |
|---|---|
| I A | 0-95 % |
| I B | 0-95 % |
| avec la condition IA+IB | 40-95 % |
| I C | 1-20 % |
| avec la condition IA+IB+IC | 50-98 % |
| II D | 0,01-25 % |
| II E | 0,1-20 % |
| II F | 0,001-1 % |
| II G | 0-20 % |
| III | 0-2000 ppm |

Les compositions de l'invention peuvent être préparées en mélangeant soigneusement les divers constituants jusqu'à obtention d'une solution homogène. La composition obtenue est utile pour produire des plaques d'enregistrement convenant à l'enregistrement d'hologrammes, notamment d'hologrammes de phase, épais ou minces. Il suffit d'appliquer une couche de la composition sur une plaque-support transparente à la longueur d'onde actinique utilisée, la couche appliquée pouvant être revêtue, si désiré, d'une plaque de couverture de

nature similaire ou différente de celle de la plaque-support. Selon un mode de réalisation particulier d'une plaque d'enregistrement, on peut coucher la composition entre deux lames séparées par un élément d'espacement d'épaisseur appropriée. Bien entendu les lames doivent être transparentes à la longueur d'onde du rayonnement utilisé pour initier la photopolymérisation. Comme source de rayonnement appropriée, on peut utiliser, par exemple, un laser dit "d'écriture" tel qu'un laser He-Ne (633 nm), un laser krypton ionisé (647, 676, 752 ou 799 nm), ou une diode laser (780-840 nm). Egalement, la lumière actinique peut être distribuée de manière continue ou intermittente (laser impulsionnel par exemple).

Les hologrammes formés peuvent être "lus" par un laser dit "de lecture" dont la longueur d'onde d'émission n'est pas absorbée par la composition photopolymérisable. L'hologramme obtenu peut être caractérisé par son rendement de diffraction $\eta$ dans l'ordre +1, qui est égal au quotient de l'intensité du faisceau diffracté par la somme de l'intensité du faisceau diffracté et de l'intensité du faisceau transmis.

Les hologrammes produits peuvent être des éléments transmetteurs ou réfléchissants selon que les deux faisceaux d'écriture arrivent du même côté de la plaque sensible ou de part et d'autre.

Les hologrammes produits à partir des compositions de l'invention peuvent être utiles pour l'enregistrement de toutes formes d'éléments optiques diffractifs tels que, par exemple, les filtres, miroirs, dispositifs correcteurs d'aberrations, éléments multiplicateurs ou toutes formes d'éléments plus élaborés présentant des fonctions optiques multiples désignés habituellement sous le nom d'éléments intégrés. Les applications dans le domaine du marquage ou de l'identification par voie optique et plus particulièrement celles utilisant les codes barres, peuvent également bénéficier de la présente invention.

Ils peuvent également servir à la copie ou à la multiplication d'hologrammes-maîtres enregistrés par des techniques quelconques sur des supports quelconques, et en particulier d'hologrammes synthétiques calculés par ordinateur.

Les hologrammes produits à partir des compositions de l'invention peuvent être utilisés tels que préparés en vue de leur enregistrement c'est-à-dire sur un support et sous une plaque de couverture éventuelle, mais ils peuvent aussi être séparés du support et de la plaque de couverture éventuelle.

Les exemples non limitatifs suivants sont donnés dans le but d'illustrer la préparation de quelques compositions selon l'invention.

Exemple I :

A 1,5 g de triacrylate de pentaérythritol, 1,8 g de tétracrylate de pentaérythritol (PETA), 0,2 g de composés d'addition entre PETA et l'acide acrylique, on additionne 0,25 g de méthyldiéthanolamine, 0,2 g d'iodoforme, 0,06 g de 2,2′-bis(o-chlorophényl)-4,4′,5,5′-tétraphénylbiimidazole et 3 mg d'hexaméthylindodicarbocyanine, en agitant jusqu'à obtention d'une solution homogène.

On prépare une plaque d'enregistrement pour la production d'un hologramme, constitué d'une couche de cette solution entre deux lames de microscope séparées par une cale d'épaisseur de 100 µm. Cette plaque est ensuite soumise à une irradiation holographique à 633 nm. L'énergie nécessaire à la production de l'hologramme est de 470 $mJ/cm^2$. Le rendement de diffraction maximal obtenu est de 6 %. Cet hologramme est stable sur quelques heures.

Exemple II :

1,5 g de triacrylate de pentaérythritol, 2,5 g de tétracrylate de pentaérythritol, 0,2 g de composés d'addition entre PETA et l'acide acrylique, 0,17 g de 9-vinylcarbazole, 0,35 g de méthacrylate de diméthylaminoéthyle, 0,3 g de tétrabromométhane et 7,5 mg d'hexaméthylindodicarbocyanine sont mélangés afin d'obtenir une solution limpide. Une plaque d'enregistrement est préparée comme à l'exemple I et irradiée avec la même quantité d'énergie. L'hologramme obtenu présente un rendement de diffraction de 28 %. Ce dernier perd 60 % de sa valeur en 24 heures.

Exemple III :

1,5 g de triacrylate de pentaérythritol, 1,8 g de tétracrylate de pentaérythritol, 0,2 g de composés d'addition entre PETA et l'acide acrylique, 3,8 g de pentaacrylate de dipentaérythritol, 0,12 g de p-diméthylamino-benzoate d'éthyle, 0,37 g de tétrabromométhane, 0,09 g d'isopropylthioxanthone et 7 mg d'hexaméthyl-indodicarbocyanine sont mélangés afin d'obtenir une solution limpide. Une plaque d'enregistrement est préparée à partir de cette composition comme décrit à l'exemple I si ce n'est qu'on a utilisé une cale d'épaisseur de 30 µm. L'énergie nécessaire pour l'obtention d'un hologramme présentant un rendement de diffraction de 15 % est de 470 $mJ/cm^2$. On observe une augmentation du rendement de diffraction de 30 % par rapport à sa valeur initiale,

après 24 heures de stockage à l'obscurité. Cet hologramme est stable sur quelques semaines.

Exemple IV :

A une solution contenant 0,75 g de triacrylate de pentaérythritol, 1,7 g de tétracrylate de pentaérythritol, 0,15 g de composés d'addition entre PETA et l'acide acrylique, 0,18 g de méthyldiéthanolamine, 0,19 g de tétrabromométhane et 0,03 g de PDO, on ajoute 1 mg d'hexaméthyl-indotricarbocyanine dont le maximum d'absorption se situe à 754 nm.

Une plaque d'enregistrement préparée comme décrit à l'exemple III est soumise à une irradiation holographique avec un laser à krypton à 752 nm. Un hologramme ayant un rendement de diffraction de 32 % est obtenu. Il a nécessité une énergie de 1,2 $W/cm^2$. En 24 heures, le rendement de diffraction a perdu 60 % de sa valeur.

Exemple V :

On a préparé une plaque d'enregistrement comme décrit à l'exemple III à l'aide d'une solution obtenue à partir de 5 g de triacrylate de pentaérythritol, 6,2 g de tétracrylate de pentaérythritol, 0,6 g de composés d'addition entre PETA et l'acide acrylique, 0,05 g de p-diméthylamino-benzoate d'éthyle, 0,9 g de tétrabromométhane et 11 mg d'hexaméthylindodicarbocyanine. Avec cette plaque on a réalisé un hologramme d'une mire USAF avec un faisceau laser de longueur d'onde égale à 647 nm.

L'énergie totale nécessaire à l'enregistrement est de 2,5 $J/cm^2$. Le rendement de diffraction obtenu est de 4 %.

L'enregistrement holographique d'un réseau plan avec un élément identique a permis d'obtenir un rendement de diffraction de 57 % avec une énergie de 750 $mJ/cm^2$.

Exemple VI :

Comme décrit à l'exemple III, on prépare une plaque d'enregistrement à l'aide d'une solution constituée de 5 g d'Ebecryl 850 (UCB), 1 g de diacrylate de tripropylène glycol (TPGDA), 0,1 g de composés d'addition entre TPGDA et l'acide acrylique, 0, 12 g de p-diméthylaminobenzoate d'éthyle, 0, 21 g de tétrabromo-méthane et 2 mg d'hexaméthylindotricarbocyanine. L'énergie nécessaire à 752 nm pour obtenir un rendement de diffraction de 18 % est de 540 $mJ/cm^2$.

Exemple VII :

On prépare une plaque d'enregistrement comme décrit à l'exemple III à l'aide d'une solution constituée de 5 g d'Ebecryl 608 (UCB), 1,8 g de diacrylate d'hexanediol (HDDA), 0,2 g de composés d'addition entre HDDA et l'acide acrylique, 0,15 g de méthyldiéthanolamine, 0,30 g d'iodoforme et 2mg de dichloro- 5,5'-hexaméthylindotricarbocyanine. L'énergie nécessaire à 799 nm pour obtenir un rendement de diffraction de 10 % est de 600 $mJ/cm^2$.

Exemple VIII :

On prépare une plaque d'enregistrement comme décrit à l'exemple I à l'aide d'une solution composée de 1,3 g de triacrylate de pentaérythritol, 1,6 g de tétraacrylate de pentaérythritol, 0,3 g de composés d'addition entre le PETA et l'acide acrylique, 2,8 g d'Ebécryl 850 (UCB), 0,36 g de méthacrylate de p-diméthylaminoéthyle, 0,33 g de iodoforme et 6 mg d'hexaméthylindodicarbocyanine. Cette plaque nécessite 600 $mJ/cm^2$ à 633 nm pour donner un hologramme diffractant 18 % de la lumière incidente. Celui-ci est stable sur quelques jours.

Exemple IX

En suivant le mode opératoire général décrit à l'exemple I, on prépare une série de plaques d'enregistrement pour la production d'hologrammes à partir de diverses compositions. Ces plaques ont été ensuite soumises à une irradiation holographique dans les conditions de l'Exemple I. Les compositions photosensibles et les résultats de l'irradiation holographique sont résumés dans le Tableau ci-dessous.

| Composition n° | I | IID | IIE | IIF | η% | Commentaires |
|---|---|---|---|---|---|---|
| 1 | + | - | - | - | 0 | pas de polymérisation |
| 2 | + | - | - | + | 0 | pas de polymérisation |
| 3 | + | - | + | - | 0 | pas de polymérisation |
| 4 | + | + | - | - | 0 | pas de polymérisation |
| 5 | + | + | + | - | 0 | pas de polymérisation |
| 6 | + | + | - | + | 0 | trace de polymérisation |
| 7 | + | - | + | + | 0 | pas de polymérisation |
| 8 | + | + | + | + | 32% | stable sur plusieurs mois |

NOTES

I. triacrylate de pentaérythritol + tétraacrylate de pentaérythritol + produit d'addition entre PETA et acide acrylique : 89 % en poids

IID : p-diméthylaminobenzoate d'éthyle : 4 % en poids

IIE : tétrabromométhane : 6,9 % en poids

IIF : hexaméthylindodicarbocyanine : 0,1 % en poids

Les résultats obtenus montrent que la présence simultanée des constituants I, IID, IIE et IIF est indispensable pour l'obtention d'une composition convenant à la réalisation d'hologrammes de phase.

Il va de soi que les modes de réalisation décrits ne sont que des exemples et l'on pourrait les modifier, notamment par substitution d'équivalents techniques, sans sortir pour cela du cadre de l'invention.

## Revendications

1. Compositions photopolymérisables, sensibles dans le rouge et le proche infrarouge, caractérisées en ce qu'elles consistent essentiellement en une solution de :
   (I) au moins une substance, non gazeuse, éthyléniquement insaturée, capable de former un haut polymère par polymérisation d'addition, à propagation en chaîne initiée par des radicaux libres, choisie dans le groupe constitué par :
      (A) les monomères contenant au moins une double liaison éthylénique,

(B) les oligomères acryliques ou méthacryliques polyfonctionnels d'une masse moléculaire de 500 à 5000, et

(C) les composés d'addition dérivés d'un acrylate ou méthacrylate de polyol et d'un acide acrylique, ou dérivés d'un oligomère I(B) et d'un acide acrylique.

(II) un système générateur de radicaux libres, sensible à des radiations comprises entre 600 nm et le proche infrarouge, comprenant

(D) au moins un agent réducteur organique,

(E) au moins un agent renforçateur de l'effet quantique,

(F) au moins un agent absorbeur de lumière dont le spectre d'absorption s'étend entre 600 nm et le proche infrarouge et qui, conjointement avec les constituants (D) et (E), est capable d'engendrer des espèces actives susceptibles d'amorcer la photopolymérisation du constituant (I).

2. Composition selon la revendication 1, caractérisée en ce que le constituant (I) comprend un constituant (I)(C).

3. Compositions selon la revendication 1, caractérisées en ce que le système générateur de radicaux libres (II) comprend, en outre, un agent stabilisateur d'amorçage (G).

4. Compositions selon la revendication 1, caractérisées en ce qu'elles comprennent, en outre, un inhibiteur de polymérisation thermique (III).

5. Compositions selon l'une quelconque des revendications 1 à 4, caractérisées en ce qu'elles ont la composition suivante, en % en poids :

| Constituants | gamme |
|---|---|
| I A | 0-95 % |
| I B | 0-95 % |
| avec la condition IA+IB | 40-95 % |
| I C | 1-20 % |
| avec la condition IA+IB+IC | 50-98 % |
| II D | 0,01-25 % |
| II E | 0,1-20 % |
| II F | 0,001-1 % |
| II G | 0-20 % |
| III | 0-2000 ppm |

6. L'utilisation d'une composition telle que définie à l'une quelconque des revendications 1 à 5 pour la production d'hologrammes.

7. L'utilisation selon la revendication 6, pour la production d'hologrammes de phase.

8. Plaques pour l'enregistrement d'hologrammes comprenant une couche de composition photosensible sur un support approprié, caractérisées en ce que la composition photosensible est une composition telle que définie à l'une quelconque des revendications 1 à 5.

Office européen des brevets

# RAPPORT DE RECHERCHE EUROPEENNE

Numero de la demande

EP 92 40 1914

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| X | EP-A-0 339 841 (THE MEAD CORPORATION)<br>* page 4, ligne 40 - ligne 45 *<br>* page 10 - page 11 *<br>* page 15, ligne 1 - ligne 11 *<br>* page 15, ligne 19 *<br>* page 15, ligne 34 *<br>* page 15, ligne 46 - ligne 47 *<br>--- | 1,3,4, 6-8 | G03F7/00<br>G03F7/031 |
| A | EP-A-0 269 397 (EASTMAN KODAK COMPANY)<br>* page 22, table II *<br>* revendications 1,8,9 *<br>----- | 1 | |
| | | | **DOMAINES TECHNIQUES RECHERCHES (Int. Cl.5 )** |
| | | | G03F |

Le présent rapport a été établi pour toutes les revendications

| Lieu de la recherche | Date d'achèvement de la recherche | Examinateur |
|---|---|---|
| LA HAYE | 08 SEPTEMBRE 1992 | DUPART J-M.B. |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)